Europäisches Patentamt

European Patent Office

Office européen des brevets

(19)

(11) EP 0 902 298 A2

(12) EUROPEAN PATENT APPLICATION

(43) Date of publication:
17.03.1999 Bulletin 1999/11

(51) Int Cl.$^6$: G01R 31/3185

(21) Application number: 98302334.2

(22) Date of filing: 26.03.1998

(84) Designated Contracting States:
AT BE CH DE DK ES FI FR GB GR IE IT LI LU MC
NL PT SE
Designated Extension States:
AL LT LV MK RO SI

(30) Priority: 12.09.1997 JP 249110/97

(71) Applicant: FUJITSU LIMITED
Kawasaki-shi, Kanagawa 211-8588 (JP)

(72) Inventors:
• Mori, Yutaka, c/o Fujitsu Limited
Kawasaki-shi, Kanagawa, 211-8588 (JP)

• Isoda, Yutaka c/o Fujitsu Limited
Kawasaki-shi, Kanagawa, 211-8588 (JP)
• Iwamoto, Naomi, c/o Fujitsu Limited
Kawasaki-shi, Kanagawa, 211-8588 (JP)
• Watanabe, Hisashi, c/o Fujitsu Limited
Kawasaki-shi, Kanagawa, 211-8588 (JP)

(74) Representative: Stebbing, Timothy Charles et al
Haseltine Lake & Co.,
Imperial House,
15-19 Kingsway
London WC2B 6UD (GB)

(54) Testing method and testing apparatus of electronic circuit

(57) There is provided a testing method of an electronic circuit (10) including an internal logic circuit (13), terminals (11a...11o), and a boundary scan circuit (12a...12l) interposed between the internal circuit and the terminals, the method comprising: a first step of setting test data in the boundary scan circuit (12a...12l) such that signals of the same level are output from all of the output terminals (12a...11o); a second step of detecting an electric current of the electronic circuit; a third step of setting the test data in the boundary scan circuit such that any one of the output terminals outputs a signal of a level different from the signals output from the remaining output terminals; a fourth step of detecting an electric current of the electronic circuit (10); and a fifth step of judging whether the one terminal is normal or abnormal based on a difference between the electric current detected in the second step and that in the fourth step. A corresponding testing apparatus (20) is also disclosed.

FIG. 1

## Description

The present invention relates to a testing method and a testing apparatus of an electronic circuit, and more particularly, to a testing method and a testing apparatus suitable for an electronic circuit having a large number of input/output pins in which the area bump system, for example, is employed.

Conventionally, in a characteristic properties test of input/output circuit such as IC, LSI, ULSI or the like, an I/O pin which is an input/output terminal is electrically connected to a tester to check its voltage, current properties and the like.

However, with the increased density of integration of the IC, LSI and the like in recent years, the number of the I/O pins tends to increase, and the number of the pins reaches as much as some thousands. When the characteristic properties test is carried out with respect to such a huge number of I/O pins, especially when the characteristic properties test is carried out with respect to I/O pins in an electronic circuit chip of the area bump system in which a large number of I/O pins are mounted on the bottom surface of the chip in a two-dimensional matrix, there are problems as follows.

First, in order to carry out the test for I/O pins of the electronic circuit chip, it was necessary to electrically contact a tester to all of the I/O pins provided in the electronic circuit chip. For this reason, in order to connect to all of the I/O pins at the same time, a structure of the tester is complicated, and the cost is increased.

Further, when the tester could not be connected to all of the I/O pins of the electronic circuit chip at the same time, connecting and disconnecting operations between the tester and each of the I/O pins had to be sequentially conducted. Such operations were troublesome, and were very difficult when the area bump system was employed in the electronic circuit chip. Therefore, the time required for the test was elongated, and the costs for the test increased.

Furthermore, the electronic circuit chip employing the area bump system is mounted on the circuit board by connecting a plurality of bumps provided on the circuit board (semicircular solders formed corresponding to the I/O pins on the circuit board) to each of the I/O pins. However, since each of the bumps is formed of solder, it is weak and a probing is difficult. Therefore, it took a time for appropriately connecting each of the I/O pins to the corresponding bumps, which elongated the testing time. Further, by such a connecting operation between the I/O pin and the bump, there were problems that the circuit board might be damaged because the bump might come off from the circuit board, or the I/O pin of the chip was physically damaged.

The present invention has been accomplished in view of the above problems, and an embodiment of the invention may provide a testing method and a testing apparatus of an electronic circuit which can be carried out at lower cost and within a shorter time as compared with the conventional method and apparatus.

According to a first aspect, there is provided a testing method of an electronic circuit including an internal logic circuit, a plurality of terminals of the internal logic circuit, and a boundary scan circuit interposed between the internal circuit and the plurality of terminals, the method comprising: a first step of setting test data in the boundary scan circuit such that signals of the same level are output from all of terminals which are output terminals among the plurality of terminals; a second step of detecting a power source electric current of the electronic circuit when an output of each of the output terminals is in a state set in the first step; a third step of setting the test data in the boundary scan circuit such that any one of the output terminals outputs a signal of a level different from the signals output from the remaining output terminals; a fourth step of detecting a power source electric current of the electronic circuit when an output of each of the output terminals is in a state set in the third step; and a fifth step of judging whether the one terminal is normal or abnormal based on a difference between the power source electric current detected in the second step and the power source electric current detected in the fourth step.

According to a second aspect, there is provided a testing method of an electronic circuit as recited in the first aspect, wherein in the first step, test data is set in the boundary scan circuit such that low level signals are output from all of terminals which are output terminals among the plurality of terminals; in the third step, the test data is set in the boundary scan circuit such that any one of the output terminals outputs a high level signal and the remaining output terminals output low level signals; and in the fifth step, the one terminal is judged as abnormal, when the difference between the power source electric current detected in the second step and the power source electric current detected in the fourth step is smaller than a threshold value.

According to a third aspect, there is provided a testing method of an electronic circuit as recited in the first aspect, wherein in the first step, test data is set in the boundary scan circuit such that high level signals are output from all of terminals which are output terminals among the plurality of terminals; in the third step, the test data is set in the boundary scan circuit such that any one of the output terminals outputs a low level signal and the remaining output terminals output high level signals; and in the fifth step, the one terminal is judged as abnormal, when the difference between the power source electric current detected in the second step and the power source electric current detected in the fourth step is equal to or greater than a threshold value.

According to a fourth aspect, there is provided a testing method of an electronic circuit including an internal logic circuit, a plurality of terminals of the internal logic circuit, and a boundary scan circuit interposed between the internal circuit and the plurality of terminals, the method comprising: a first step of setting test data in the boundary scan circuit such that signals of a predetermined level are output to a testee terminal among the plurality of terminals; a second step of bringing an output to the testee terminal into a high impedance state; and a third step of judging whether the testee terminal is normal or abnormal, based on a time in which a level of output to the testee terminal maintains the predetermined level after the high impedance state is established in the second step.

According to a fifth aspect, there is provided a testing method of an electronic circuit as recited in the fourth aspect, wherein the boundary scan circuit comprises a buffer connected to the terminals, and test data holding means for holding test data to be supplied to the buffer, and wherein in the first step, the test data is set in the test data holding means such that a signal of the predetermined level is output from the buffer; in the second step, the buffer is set in a high impedance state; and in the third step, the testee terminal is judged whether it is normal or abnormal, based on a time in which a level of output to the testee terminal maintains the predetermined level.

According to a sixth aspect, there is provided a testing method of an electronic circuit as recited in the fifth aspect, wherein the boundary scan circuit comprises a buffer output holding means in which data having a level in accordance with an output of the buffer is stored, and wherein in the third step, the testee terminal is judged whether it is normal or abnormal, based on a time in which the data stored in the buffer output holding means maintains a level in accordance with the predetermined level.

According to a seventh aspect, there is provided a testing method of an electronic circuit as recited in the sixth aspect, wherein the third step detects a level of data stored in the buffer output holding means after a predetermined time is elapsed after the buffer is brought into the high impedance state.

According to an eighth aspect, there is provided a testing method of an electronic circuit as recited in the fourth to seventh aspects, wherein in the first step, the predetermined level is defined as a low level.

According to a ninth aspect, there is provided a testing method of an electronic circuit as recited in the fourth to seventh aspects, wherein in the first step, the predetermined level is defined as a high level.

According to a tenth aspect, there is provided a testing apparatus of an electronic circuit including an internal logic circuit, a plurality of terminals of the internal logic circuit, and a boundary scan circuit interposed between the internal circuit and the plurality of terminals, comprising: control means, for setting a first state by setting test data in the boundary scan circuit such that signals of the same level are output from all of terminals which are output terminals among the plurality of terminals, and for setting a second state by setting test data in the boundary scan circuit such that the output terminals except any one of them output signal of the level, and the one of the terminals output a signal of a different level; electric current detecting means for detecting a power source electric current of the electronic circuit in the first state, and the power source electric current of the electronic circuit in the second state; and judging means for judging whether the one of the terminals is normal or abnormal, based on a difference between the power source electric current of the electronic circuit in the first state, and the power source electric current of the electronic circuit in the second state.

According to an eleventh aspect, there is provided a testing apparatus of an electronic circuit as recited in the tenth aspect, wherein the control means sets the first state by setting the test data in the boundary scan circuit such that signals of low level are output from all of terminals which are output terminals, and sets the second state by setting the test data in the boundary scan circuit such that a signal of high level is output from any one of the output terminals, and signals of low level are output from the remaining output terminals; and the judging means judges that the one of the terminals is abnormal when the difference in the power source electric current is smaller than a threshold value.

According to a twelfth aspect, there is provided a testing apparatus of an electronic circuit as recited in the tenth aspect, wherein the control means sets the first state by setting the test data in the boundary scan circuit such that signals of high level are output from all of terminals which are output terminals, and sets the second state by setting the test data in the boundary scan circuit such that a signal of low level is output from any one of the output terminals, and signals of high level are output from the remaining output terminals; and the judging means judges that the one of the terminals is abnormal when the difference in the power source electric current is equal to or greater than a threshold value.

According to a thirteenth aspect, there is provided a testing apparatus of an electronic circuit including an internal logic circuit, a plurality of terminals of the internal logic circuit, and a boundary scan circuit interposed between the internal circuit and the plurality of terminals, comprising: control means for setting a first state by setting test data in the boundary scan circuit such that a signal of a predetermined level is output to a testee terminal among the plurality of terminals and then, the control means setting a second state by setting the test data in the boundary scan circuit such that the output to the testee terminal is brought into a high impedance state; and judging means for judging, after the high impedance state is set by the control means, whether the testee terminal is normal or abnormal, based on a time in which the level of the output to the testee terminal maintains the predetermined level.

According to a fourteenth aspect, there is provided a testing apparatus of an electronic circuit as recited in the thirteenth aspect, wherein the boundary scan circuit comprises a buffer connected to the terminals, and test data holding means for holding test data to be supplied to the buffer; the control means sets the first state by storing the test data in the test data holding means such that the signal of the predetermined level is output from the buffer and then, the control means sets the second state by setting the test data in the test data holding means such that the buffer is brought into the high impedance state; and the judging means judges whether the testee terminal is normal or abnormal based on a time in which the output of the buffer maintains the predetermined level.

According to a fifteenth aspect, there is provided a testing apparatus of an electronic circuit as recited in the fourteenth aspect, wherein the boundary scan circuit further comprises buffer output holding means in which data of a level in accordance with the output of the buffer is stored; and the judging means judges whether the testee terminal is normal or abnormal based on a time in which the data stored in the buffer output holding means a level in accordance with the predetermined level.

According to a sixteenth aspect, there is provided a testing apparatus of an electronic circuit as recited in fifteenth aspect, wherein the judging means detects a level of the data stored in the buffer output holding means after a predetermined time is elapsed after the buffer is brought into the high impedance state, and judges whether the testee terminal is normal or abnormal based the detected level.

According to a seventeenth aspect, there is provided a testing apparatus of an electronic circuit as recited in the thirteenth to sixteenth aspects, wherein the control means sets the first state by setting the test data in the boundary scan circuit such that a signal of low level is output to the testee terminal.

According to an eighteenth aspect, there is provided a testing apparatus of an electronic circuit as recited in the thirteenth to sixteenth aspects, wherein the control means sets the first state by setting the test data in the boundary scan circuit such that a signal of high level is output to the testee terminal.

Reference will now be made, by way of example, to the accompanying drawings in which:-

Fig.1 is a block diagram of an electronic circuit according to an embodiment of the present invention;
Fig.2 is a block diagram of a BS macro and a JTAG control circuit shown in Fig.1;
Fig.3 is a detailed diagram for explaining the BS macro shown in Fig.2;
Fig.4 is a diagram for explaining a testing method;
Fig.5 is a diagram for explaining a testing method;
Fig.6 is a flowchart of a first embodiment;
Fig.7 is a flowchart of a second embodiment;
Fig.8 is a flowchart of a third embodiment; and
Fig.9 is a flowchart of a fourth embodiment.

Embodiments of the present invention will be described with reference to the accompanying drawings below.

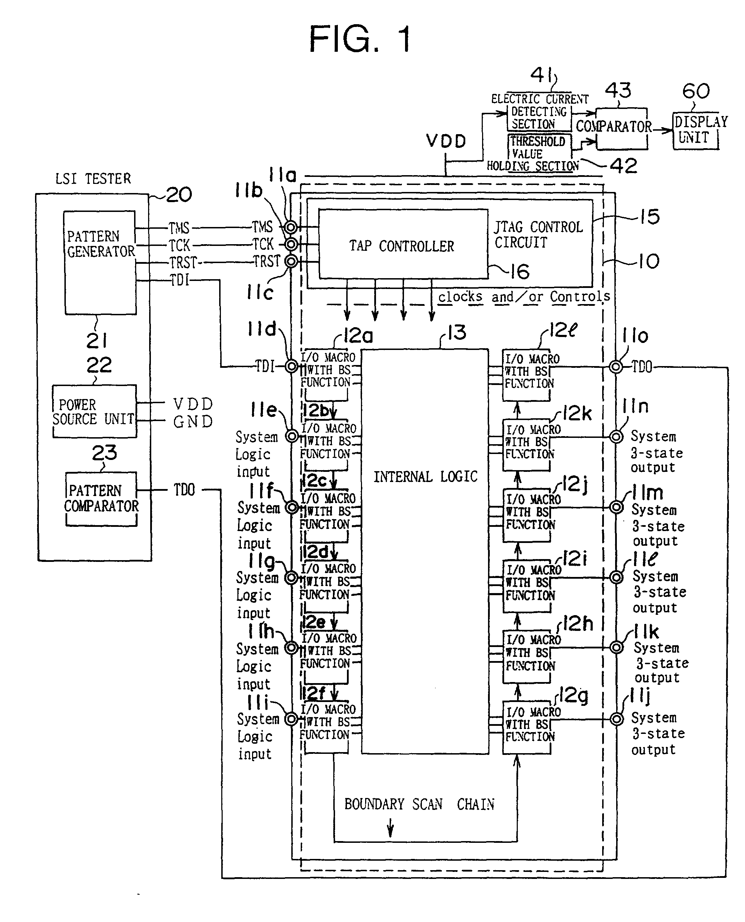

Fig.1 is a block diagram of an electronic circuit (a block diagram of a testing apparatus of an electronic circuit) by which a testing method according to embodiments of the present invention is conducted. Fig.1 shows an LSI chip (electronic circuit chip: which will be referred to as "chip" hereinafter) 10, and an LSI tester 20 electrically connected to the chip 10.

The LSI tester 20 includes a pattern generator 21 for supplying to the chip 10 various data for testing the chip 10, a power source unit 22 for supplying an operating voltage to various portions of the chip 10, and a pattern comparator 23 for comparing an output pattern from the chip 10 with a previously prepared test pattern.

Mounted on the chip 10 is a boundary scan circuit compliant with "IEEE standard 1149.1" which is a worldwide standard prescribed by IEEE (Institute of Electrical and Electronics engineers) whose main portions are defined by JTAG (Joint Test Action Group).

That is, the chip 10 is provided with a plurality of I/O pins 11 (I/O pins lla to llo are shown in Fig.1). Among the plural I/O pins lla to 11o, the I/O pins 11d to lln are connected to an internal logic (circuit) 13 constituting an LSI, through an I/O macro 12 (which will be referred to as "BS macro" hereinafter) each including a boundary scan function (BS macros 12a to 12l are shown in Fig.1).

The adjacent BS macros 12a to 12l are connected to one another, and are disposed on one side of the boundary with respect to the I/O pins 11d to 11o such as to surround the internal logic 13. These BS macros 12a to 12l are controlled by the JTAG control circuit 15 mounted on the chip 10. These BS macros 12a to 12l as well as the JTAG control circuit 15 constitute the above-described boundary scan circuit. By controlling the BS macros 12a to 12l by the JTAG control circuit 15, a test for checking the quality of the I/O pins lld to 11o or the internal logic 13 is carried out.

Among the plurality of I/O pins lla to llo, the I/O pins 11e to 11n function as I/O terminals of the internal logic 13. Whereas, each of the I/O pins lla to lld and llo functions as a test access port (TAP) for the chip 10.

The I/O pins 11a to 11c are connected to a pattern generator 21 in the LSI tester 20, and are also connected to a TAP controller 16 in the JTAG control circuit 15. A TMS (Test Mode Select) signal is input to the I/O pin lla. The TMS signal is a logic level which is necessary for state transition of the TAP controller 16. A TCK (Test Clock) signal is input to the I/O pin 11b. The TCK signal is a test clock which is independent from an operating clock of the internal logic 13. A TRST (Test Reset) signal is input to the I/O pin 11c. The TRST signal is a reset signal for the JTAG control circuit 15 and the BS macros 12a to 12l.

The I/O pin 11d is connected to the pattern generator 21, and is also connected to the BS macro 12a. A TDI (Test Data Input) signal is serially input to the I/O pin 11d. The TDI signal is an instruction bit for the test data or the BS macros 12. The I/O pin llo is connected to the BS macro 12l, and is also connected to the pattern comparator 23. A TDO (Test Data Output) signal is serially output from this I/O pin 11o. The TDO signal is a serially input test data, or an output signal from the internal logic 13.

A power source terminal of the chip 10 between the power source unit 22 and the chip 10 is provided with an electric current detecting section 41 for detecting an electric current of the entire chip 10. There is also provided a threshold value holding section 42 which holds a threshold value to be compared with an electric current value detected by the electric current detecting section 41. There is further provided another comparator 43 for comparing the electric current value detected by the electric current detecting section 41 with the threshold value to judge the quality of each of the I/O pins 11d to 11o. A display unit 60 is connected to the comparator 43.

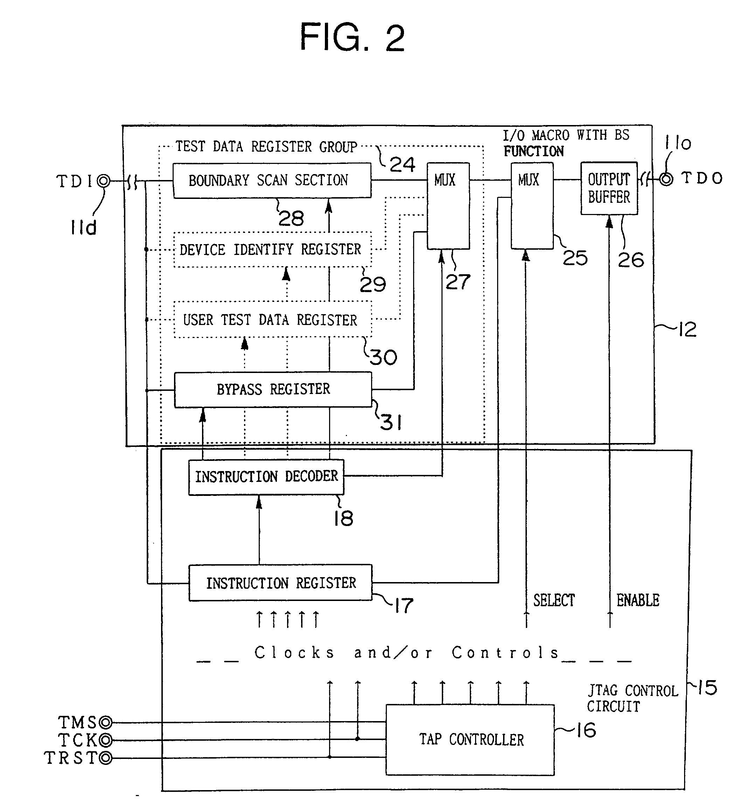

Fig.2 is a block diagram showing an internal structure of the JTAG control circuit 15 and the BS macro 12 (macros 12a to 12l) shown in Fig.1. In Fig.2, the BS macro 12 includes a test register group 24, a multiplexer (which will be referred to as "MUX" hereinafter) 25 connected to the test data register group 24, and an output buffer 26 connected to the MUX 25.

The test data register group 24 includes a boundary scan section 28 to which the TDI signal input from the I/O pin 11d is input, a device identify register 29, a user test data register 30 and a bypass register 31. These elements of the test data group 24 are connected to an MUX 27, and the MUX 27 is connected to the above-described MUX 25.

Test data included in the TDI signal is set in the boundary scan section 28. Data for identifying a device to be tested included in the TDI signal is set in the device identify register 29. User test data included in the TDI signal is set in the user test data register 30. In a case where the chip 10 is provided in plural, when the TDI signal is transmitted from the pattern generator 21 to one of the chips 10 via another chip 10, one bit for transmitting the TDI signal through the shortest path is set in the bypass register 31.

The JTAG control circuit 15 comprises the above-described TAP controller 16, an instruction register 17 and an instruction decoder 18 and the like. The instruction register 17 is connected to the I/O pin 11d, and an instruction bit included in the TDI signal is set therein. The instruction bit set in the instruction register 17 is input to the instruction decoder 18.

The instruction decoder 18 decodes the input instruction bit, and supplies the instructions based on the result to any of the boundary scan section 28, the device identify register 29, the user test data register 30 or the bypass register 31. Each of the boundary scan section 28, the device identify register 29, the user test data register 30 and the bypass register 31, upon reception of the instructions from the instruction decoder 18, executes a process based on the instructions.

The instruction decoder 18 supplies selection instructions based on the decoding result to the MUX 27. Then, the MUX 27 transmits, to the MUX 25, data held by any of the boundary scan section 28, the device identify register 29, the user test data register 30 and the bypass register 31.

The TAP controller 16 distributes the TCK signal, i.e., test clock to each of the instruction register 17, the instruction decoder 18 and the BS macro 12, and supplies a control signal in accordance with the test clock and the TMS signal. In Fig.2, detailed transmitting paths of the test clock and the control signal are omitted.

The TAP controller 16 supplies to, e.g., the instruction register 17, instructions to the effect that the instruction bit should be transferred to the instruction decoder 18. Further, the TAP controller 16 supplies, to the MUX, a select signal for selecting one of the instruction bit set in the instruction register 17 and the output from the MUX 25.

The output buffer 26 holds, at the time of enable, an output from the MUX 25. The content held in the output buffer 26 is output from the I/O pin 11. On the other hand, at the time of disable, the output buffer 26 loses such a data holding function, and functions as a resistance.

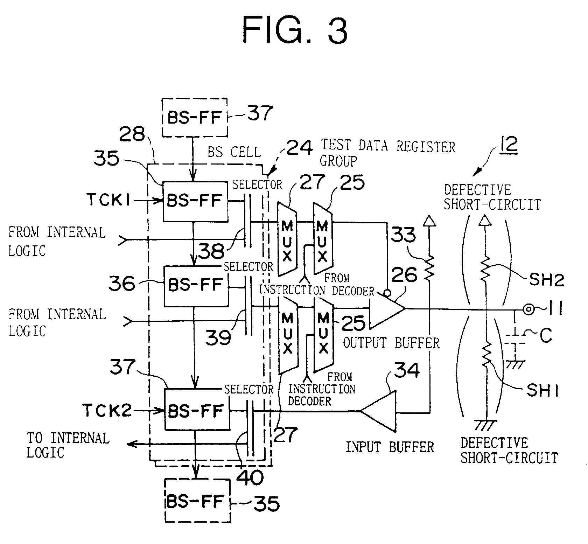

Fig.3 is a detailed diagram for explaining the BS macro shown in Fig.2. Each of the BS macros 12a to 12l shown in Fig.1 has the same structure. In Fig.3, the boundary scan section 28 of the test data register group 24 includes boundary scan flip-flop (which will be referred to as "BS-FF" hereinafter) 35 to 37, a selector 38 and a selector 39.

An input terminal of the selector 38 is connected to an output terminal of the BS-FF 35 and an output terminal of the internal logic 13, and an output terminal of the selector 38 is connected to the above-described MUX 27. Similarly, an input terminal of the selector 39 is connected to an output terminal of a BS-FF 36 and the output terminal of the internal logic 13, and an output terminal of the selector 39 is connected to the above-described MUX 27. A pull-up resistor 33 and an input terminal of an input buffer 34 are connected to a signal line which connects the output buffer 26 and the I/O pin 11. An output terminal of the input buffer 34 is connected to the BS-FF 37 and the input terminal of the internal logic 13 via a selector 40.

The BS-FF 35 is connected to the BS-FF 36, and the BS-FF 36 is connected to the BS-FF 37. The BS-FF 35 is connected to adjoining another BS-FF 37 of the BS macro 12, and the BS-FF 37 is connected to adjoining another BS-FF 35 of the BS macro 12. In this manner, the BS-FFs 35 to 37 in each of the BS macros 12a to 12l are linked together one to another, whereby a so-called boundary scan chain is formed. The TCK signal, i.e., the test clock is input to each of the BS-FF 35 to 37.

Test data ("0" signal or "1" signal) included in the TDI signal input from the I/O pin 11d is input to the BS-FF 37 through the input buffer 34 and the selector 40. In a state where the BS-FF 37 holds "0" or "1", if "0" or "1" is output from the input buffer 34, the BS-FF 37 inputs the content held in the BS-FF 37 itself to the BS-FF 35 connected this BS-FF 37 in accordance with the test clock, and holds "0" or "1" output from the input buffer 34.

However, only the BS-FF 37 of the BS macro 12a receives "0" or "1" from the input buffer 34, and each of other BS-FFs 37 of the BS macros 12b to 12l receives "0" or "1" from the own BS-FF 36 which is connected to the concerned BS-FF 37 itself.

On the other hand, if "0" or "1" is output from the BS-FF 37 connected to BS-FF 35, the concerned BS-FF 35 inputs the content held in the BS-FF 35 itself to the BS-FF 36 connected to BS-FF 35 in accordance with the test clock, and holds "0" or "1" output from the concerned BS-FF 37. Similarly, if "O" or "1" is output from the BS-FF 35 connected to BS-FF 36, the concerned BS-FF 36 inputs the content held in the BS-FF 36 itself to the BS-FF 37 connected to BS-FF 36 in accordance with the test clock, and holds "0" or "1" output from the concerned BS-FF 35.

In this manner, whenever "0" or "1" which is test data is output from the selector 40 of the BS macro 12a to the BS-FF 37, the contents held in the BS-FFs 35 to 37 in the BS macros 12b to 12m are transmitted (shifted) to the adjoining BS-FFs 35 to 37 in an extruding manner, whereby test data is sequentially transmitted in the order of BS macros 12a ->12b-> 12c->...->12l.

When "0" or "1" input from the I/O pin 11d reaches the BS-FF 36 of the BS macro 12l, if "0" or "1" is output from the BS-FF 35 of the BS macro 12l, the content held in the concerned BS-FF 36 is output from the I/O pin 11o as TDO.

The selector 38 transmits one of the content held in the BS-FF 35 and the output from the internal logic 13 to the MUX 27 in accordance with a control signal from the TAP controller 16. Similarly, the selector 39 transmits one of the content held in the BS-FF 36 and the output from the internal logic 13 to the MUX 27 in accordance with a control signal from the TAP controller 16. With such processes, the output from the internal logic 13 or the content held in the BS-FF 35 and 36 is output from the I/O pin 11. The selector 40 transmits the output from the input buffer 34 to one of the BS-FF 37 and the internal logic 13 in accordance with a control signal from the TAP controller 16.

The above-described chip 10 is designed to operate on two modes, i.e., a normal operating mode and a test operating mode. On the normal operating mode, the selector 40 transmits the output from the input buffer 34 only to the internal logic 13, the selector 38 transmits the output from the internal logic 13 to the MUX 27, and the selector 39 transmits the output from the internal logic 13 to the MUX 27. Therefore on the normal operating mode, the chip 10 operates in a state where the internal logic 13 does not receive, at all, influences by the BS-FF 35 to 37 of the BS macros 12a to 12l.

Whereas, on the test operating mode, the selector 40 transmits the output from the input buffer 34 to the BS-FF 37, the selector 38 transmits the content held in the BS-FF 35 to the MUX 27, and the selector 39 transmits the content held in the BS-FF 36 to the MUX 27. Therefore, on the test operating mode, tests of the I/O pins 11d to 11o are carried out while ignoring the internal logic 13 of the chip 10.

In the test operating mode, each of the contents held in the BS-FF 35 and BS-FF 36 is input to the output buffer 26 through the selector 38 (selector 39), the MUXs 27 and 25. In this case, the output buffer 26 operates in the following three conditions in accordance with the contents held in the BS-FF 35 and the BS-FF 36.

That is, when test data is not held in the BS-FF 35 and/or the BS-FF 36, the output buffer 26 outputs "1" signal (HIGH signal) by the pull-up resistor 33 and a capacitor C incorporated in the I/O pin 11. Whereas, when "0" signal (LOW signal) is input from the BS-FF 35 and "1" is input from the BS-FF 36, the output buffer 26 outputs a HIGH signal. That is, electric current flows to the I/O pin 11.

Further, when "0" signal is input from each of the BS-FF 35 and the BS-FF 36, the output buffer 26 outputs the LOW signal. That is, electric current does not flow to the I/O pin 11. However, when "1" is input from the BS-FF 35, the output buffer 26 is brought into a disable state, i.e., a high impedance state (HZ state), and electric current does not flow to the I/O pin 11.

[Operations in Tester and Chip]

Next, operations of the LSI tester 20 and the chip 10 on the test operating mode will be described. In the test operating mode, the LSI tester 20 and the TAP controller 16 are operated as follows:

That is, the power source unit 22 of the LSI tester 20 shown in Fig.1 supplies an operating voltage to the chip 10. Next, the pattern generator 21 supplies the TMS signal and the TCK signal to the TAP controller 16 of the JTAG control circuit 15 through the I/O pins 11a and 11b, and supplies the instruction bit which is the TDI signal to the TAP controller 16 of the JTAG control circuit 15 through the I/O pin 11d.

The instruction bit (EXTEST instructions) input from the I/O pin lld is set in the instruction register 17 of the JTAG control circuit 15. Next, the pattern generator 21 sequentially inputs test data ("0" or "1") as TDI signal to the BS macro 12 through the I/O pin 11d. That is, a test pattern comprising a plurality of test data output from the pattern generator 21 is serially input to the I/O pin 11d.

Then, the TAP controller 16 supplies the test clock or control signal to the instruction register 17 or BS macros 12a to 12l in accordance with the input TMS signal and TCK signal. With this operation, the instruction bit set in the instruction register 17 is decoded by the instruction decoder 18, and instructions based on the decoded result are supplied to the boundary scan section 28.

In the boundary scan section 28, "0" or "1" which is test data is sequentially shifted through the BS-FFs 35 to 37 of the BS macros 12a to 12l in accordance with instructions received from the instruction decoder 18 or test clock distributed by the TAP controller 16. And finally, test data are set in all of the BS macros 12a to 12l, or in the BS-FFs 35 to 37 in any of the BS macros 12a to 12l. Thereafter, a quality test is carried out for the I/O pins 11d to 11o by the testing method which will be described below.

[First Testing Method]

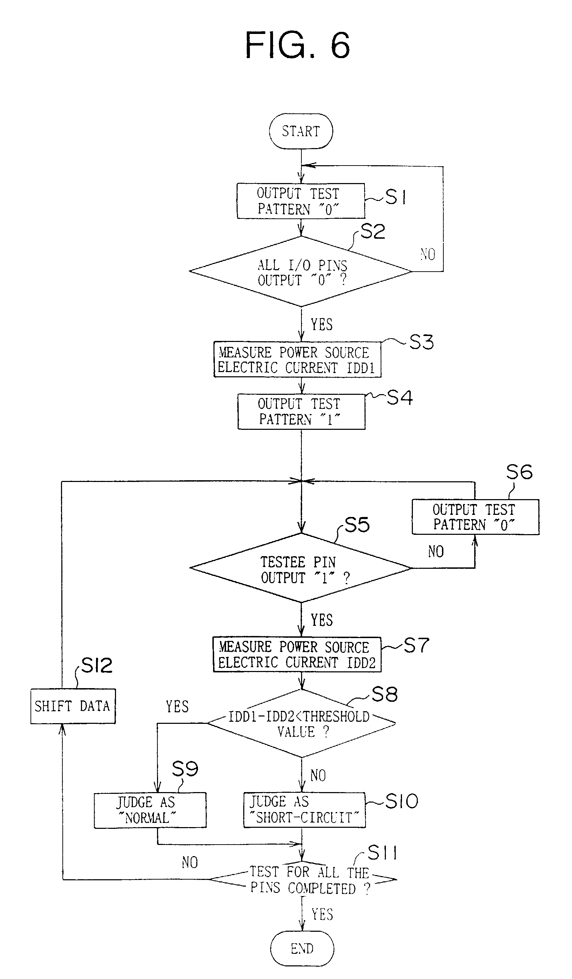

A quality test for the I/O pins 11d to 11o of the chip 10 by a first testing method (first embodiment) will be described with reference to a flowchart in Fig.6. The first testing method is a test for judging whether each of the I/O pins 11d to 11o is short-circuited with ground (GND).

First, the pattern generator 21 ad the JTAG control circuit 15 set a state where the LOW signal is output from the I/O pins 11d to 11o using the BS macros 12a to 12l. That is, "O" is held in each of the BS-FFs 35 to 37 of the BS macros 12a to 12l shown in Fig.3, "0" signal from the BS-FF 35 is inverted and input to an enable pin in each of the output buffers 26 of the BS macros 12a to 12l (enable state), and "0" is input from each of the BS-FFs 36 to the input terminals. This state is realized by making the pattern generator 21 sequentially output "0" as test data, and by making the TAP controller 16 control each of the BS-FFs 35 to 37 to hold "0" (S1, S2).

Next, the electric current detecting section 41 detects the electric current flowing to power source terminals of the entire chip 10 to obtain an electric current value IDD1 which is electric current of power source of the entire chip 10 when LOW signals are output from all of the I/O pins lld to 11o (S3).

Then, a HIGH signal is output from a pin to be tested (testee pin) among the I/O pins 11d to 11o, LOW signals are output from the remaining pins (non-testee pin). For example, the pattern generator 21 outputs "1" as test data (S4), and then outputs "0" sequentially. In accordance with this, contents (test data) held in the BS-FFs 35 to 37 are shifted to adjacent BS-FFs 35 to 37 in accordance with the test clock.

Then, only one of the BS-FFs 35 to 37 of the BS macros 12a to 12l holds "1", the rest of the BS-FFs 35 to 37 hold "0", and finally, the BS-FF 35 of one of the BS macro 12 among the BS macros 12a to 12l holds "0" and BS-FF 36 holds "1" (S5, S6). An I/O pin 11 which is connected to a BS macro 12 having such BS-FF 35 and the BS-FF 36 in this state is testee pin, and remaining I/O pins connected to other BS macros 12 are non-testee pins.

Next, the electric current detecting section 41 detects electric current flowing to power source terminals of the entire chip 10 (S7). That is, an electric current value IDD2 which is electric current of power source of the entire chip 10 when a HIGH signal is output from a testee pin among the I/O pins 11d to 11o and LOW signals are output from non-testee pins is obtained (S7).

Next, the electric current detecting section 41 obtains an electric current value ΔIDDO which is output from the testee pin by carrying out a calculation of the following (equation 1):

$$IDD1 - IDD2 = \Delta IDD0 \qquad \text{(equation 1)}$$

Here, the electric current value ΔIDDO is a difference between electric current flowing through the pull-up resistor 33 connected to the testee pin when HIGH signal is output from the output buffer 26 connected to the testee pin, and electric current flowing when LOW signal is output from the output buffer 26. When the testee pin is short-circuited with ground (GND) (see resistor SH1 in Fig.3), the electric current value ΔIDDO becomes smaller as compared with a case where the testee pin is normal. The electric current detecting section 41 supplies the obtained electric current value ΔIDDO to the comparator 43.

Next, when the comparator 43 receives the electric current value ΔIDDO from the electric current detecting section 41, the comparator 43 receives a predetermined threshold value from the threshold value holding section 42, and compares both the values (S8). At that time, when the electric current value Δ IDDO is equal to or greater than the threshold value, the comparator 43 judges that the testee pin is normal (S9). Whereas, if the electric current value ΔIDD0 is smaller than the threshold value, the comparator 43 judges that the testee pin is short-circuited (S10). Then the comparator 43 supplied the judgment result to the display unit 60.

When the display unit 60 receives the judgment result from the comparator 43, the display unit 60 displays the judgment result. Therefore, if an operator of this test sees the display unit 60, he or she can understand the quality of the testee pin, i.e., whether or not the testee pin is short-circuited.

Thereafter, test data held in each of the BS-FFs 35 to 37 of the BS macros 12a to 12l are sequentially shifted, thereby changing the I/O pin 11 which outputs the HIGH signal, i.e., the testee pin (S11, S12). In the present embodiment, the testee pin is changed by shifting test data held in each of the BS-FFs 35 to 37 three times. Therefore, every time when each test data is shifted three times, the above-described test for a testee pin is carried out.

Further, since a BS-FF which holds "1" can be specified from the order of output of the test data from the pattern generator 21, it is possible to specify or find which pin is the testee pin which is tested at present.

[Example of the Test by the First Testing Method]

The above-described first testing method will be described using concrete numeric values. For example, when a testee pin is normal (good), passing-through electric current $\Delta$IDS of the testee pin when HIGH signal is output from the output buffer 26 is only leak current to the GND. This leak current is nA order which is so small, and thus is negligible. Therefore, the electric current $\Delta$IDS passing through a normal testee pin is conceived as follows:

$$\Delta \text{IDS} = 0\text{mA}$$

The relationship between the passing-through electric current $\Delta$IDS and the electric current value $\Delta$IDDO is as follows:

$$\Delta \text{IDDO} = \Delta \text{IDS} + \text{IDS2} \qquad \text{(equation 2)}$$

wherein IDS2 is leak current of the internal logic 13, and its value is in a range of 1 to 10mA.

Wwhereas, when the testee pin is short-circuited with the GND (defective), an assumption is made that voltage of the power source is 3.3V, a value of a short-circuit resistance (resistor SH1) is a range of about 0.1 to 1k$\Omega$, and a resistance (output Pch-Tr On resistance) when P-channel type transistor is ON is in a range of 0.025 to 0.1k$\Omega$, the electric current $\Delta$IDS passing through a normal testee pin is obtained by the following calculation:

$$\Delta \text{IDS} = \text{voltage of power source} / (\text{output Pch-Tr On resistance} + \text{short-circuit resistance})$$

$$= 3.3\text{V} / (0.025 \text{ to } 0.1 \text{ k}\Omega + 0.1 \text{ to } 1\text{k}\Omega)$$

$$= 3.0 \text{ to } 26.4\text{mA}$$

Therefore, if a threshold value held in the threshold value holding section 42 is set to 3.0mA for example, a quality judgment of the testee pin can be made.

The passing-through current $\Delta$IDS per one pin of normal non-testee pin (I/O pin 11 when the LOW signal is output from the output buffer 26) is obtained by the following (equation 3):

$$\Delta \text{IDS} = \text{voltage of power source} / \text{resistance value of pull-up resistor 33} \qquad \text{(equation 3)}$$

If a voltage of the power source is 3.3V, and a resistance value of the pull-up resistor 33 is in a range of 5 to 20 k$\Omega$

$$\Delta \text{IDS} = 3.3\text{V} / 5 \text{ to } 20\text{k}\Omega$$

$$= 0.615 \text{ to } 0.66\text{mA}$$

The first testing method can be applied to a chip which does not include the pull-up resistor 33.

EP 0 902 298 A2

[Second Testing Method]

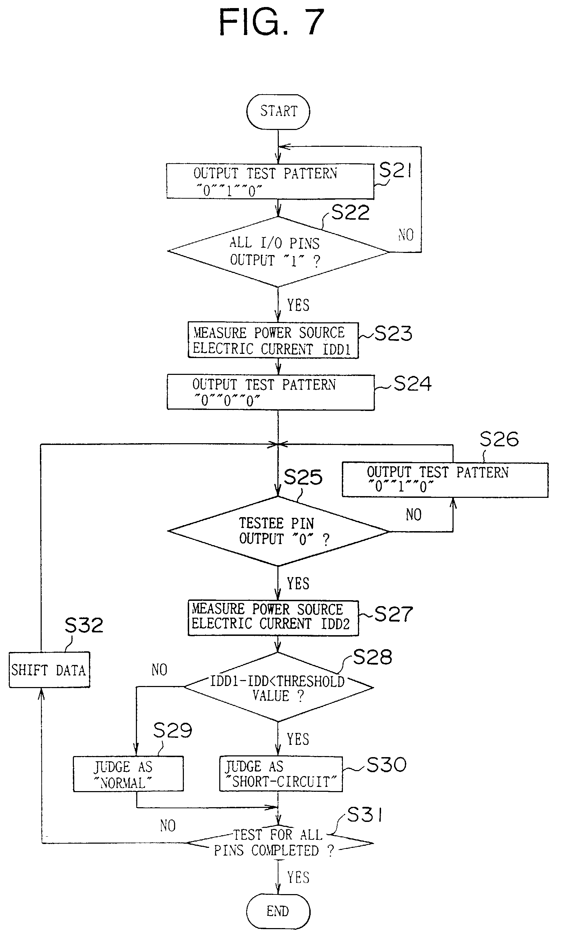

A quality test for the I/O pins 11d to 11o of the chip 10 by a second testing method (second embodiment) will be described with reference to a flowchart in Fig.7. The second testing method is a test for judging whether each of the I/O pins 11d to 11o is short-circuited with a voltage source (VDD). The second testing method is substantially the same as the first testing method, and differences are mainly described.

First, using technique described in the first testing method, the pattern generator 21 and JTAG control circuit 15 set a state where the HIGH signal is output from the I/O pins 11d to 11o. That is, "0" is input from the BS-FF 35 to each of the output buffers 26 of the BS macros 12a to 12l, and "1" is input from the BS-FF 36. At that time, a pattern of test data output from the pattern generator 21 becomes, for example, a repetition of "0", "1", "0" (S21, S22).

Next, the electric current detecting section 41 detects the power source electric current from the power source terminal of the entire chip 10. That is, an electric current value IDD1 which is a power source electric current of the entire chip 10 when HIGH signals are output from all of the I/O pins 11d to 11o is obtained (S23).

Then, a LOW signal is output from a pin to be tested (testee pin) among the I/O pins 11d to 11o, and HIGH signals are output from the remaining pins (non-testee pins). That is, each of the BS-FF 35 and BS-FF 36 of one of the BS macros 12 among the BS macros 12a to 12l holds "0". An I/O pin 11 connected to the concerned BS macro 12 having the BS-FF 35 and the BS-FF 36 in this state is a testee pin, and other I/O pins 11 connected to other BS macros 12 are non-testee pins. This state can be realized to mix a pattern ("0", "0", "0") into the above-described repetition pattern ("0", "1", "0") only one time (S24, S25, S26).

Next, the electric current detecting section 41 detects the power source electric current from the power source terminal of the entire chip 10. That is, an electric current value IDD2 which is the power source electric current of the entire chip 10 when a LOW signal is output from the testee pin among the I/O pins 11d to llo and HIGH signals are output from non-testee pins are output is obtained (S27).

Then, the electric current detecting section 41 calculates the above-described (equation 1), thereby obtaining the electric current value ΔIDDO output from the testee pin. The electric current value ΔIDDO is electric current flowing into the output buffer 26 connected to the testee pin. When the testee pin is short-circuited between the testee pin and the voltage source VDD(see resister SH2 in Fig.3), this electric current value ΔIDD O becomes greater as compared with a case where the testee pin is normal. The electric current detecting section 41 supplies the obtained electric current value ΔIDDO to the comparator 43.

Next, when the comparator 43 receives the electric current value ΔIDDO from the electric current detecting section 41, the comparator 43 receives a predetermined threshold value from the threshold value holding section 42, and compares both the values (S28). At that time, when the electric current value ΔIDDO is smaller than the threshold value, the comparator 43 judges that the testee pin is normal (S29). Whereas, if the electric current value ΔIDDO is equal to or greater than the threshold value, the comparator 43 judges that the testee pin is short-circuited (S30). Then the comparator 43 supplied the judgment result to the display unit 60. When the display unit 60 receives the judgment result from the comparator 43, the display unit 60 displays the judgment result.

Thereafter, test data held in each of the BS-FFs 35 to 37 of the BS macros 12a to 12l are sequentially shifted, thereby changing the I/O pin 11 which outputs the LOW signal, i.e., the testee pin (S31, S32). In the present embodiment, the testee pin is changed by shifting test data held in each of the BS-FFs 35 to 37 three times. Therefore, every time when each test data is shifted three times, the above-described test for a testee pin is carried out.

Further, since it is possible to determine in which one of the BS macros 12a to 12l, the pattern ("0", "0", "0") exists, from the order of output of the test data from the pattern generator 21, it is possible to specify or find which pin is the testee pin which is tested at present.

[Example of the Test by the Second Testing Method]

The above-described second testing method will be described using concrete numeric values. For example, when a testee pin is normal (good), passing-through electric current ΔIDS of the testee pin when LOW signal is output from the output buffer 26 is obtained by the above-described (equation 3).

Here, if it is supposed that that a voltage of the power source is 3.3V as in the first testing method, and a resistance value of the pull-up resistor 33 is in a range of 5 to 20 kΩ, the passing-through electric current ΔIDS will be as follows:

$$\Delta IDS = 3.3V / 5 \text{ to } 20 \text{ k}\Omega$$

$$= 0.615 \text{ to } 0.66mA$$

9

Whereas, when the testee pin is short-circuited with the voltage source VDD (defective), an assumption is made that a voltage of the power source is 3.3V, a value of a short-circuit resistance (resistor SH2) is in a range of about 0.1 to 1 k$\Omega$, and a resistance (output Nch-Tr On resistance) when N-channel type transistor is ON is in a range of 0.025 to 0.1 k$\Omega$, the electric current $\Delta$IDS passing through a normal testee pin is obtained by the following calculation:

$$\Delta\text{IDS} = \text{voltage of power source} / (\text{output Nch-Tr On resistance} + \text{short-circuit resistance})$$

$$= 3.3\text{V} / (0.025 \text{ to } 0.1 \text{ k}\Omega + 0.1 \text{ to } 1\text{k}\Omega)$$

$$= 3.0 \text{ to } 26.4\text{mA}$$

Therefore, if a threshold value held in the threshold value holding section 42 is set to 3.OmA, a quality judgment of the testee pin can be made.

The passing-through current $\Delta$IDS per one pin of normal non-testee pin is the same as the passing-through current $\Delta$IDS and thus, the passing-through current $\Delta$IDS can be conceived to be 0mA.

[Third Testing Method]

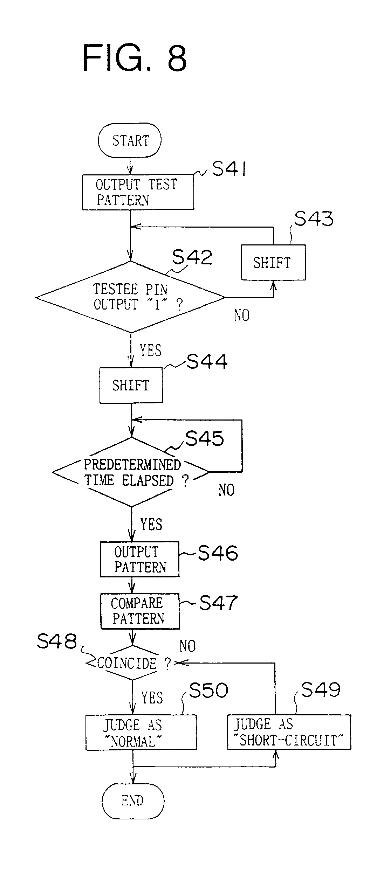

A quality test for the I/O pins 11d to 11o of the chip 10 by a third testing method (third embodiment) will be described with reference to a flowchart in Fig.8. The third testing method is a test for judging whether each of the I/O pins 11d to 11o is short-circuited with ground (GND).

First, the pattern generator 21 and the JTAG control circuit 15 specifies one BS macro 12 among the BS macros 12a to 12l, and an I/O pin 11 which is connected to the specified BS macro 12 is determined as a testee pin, and a HIGH signal is output from this testee pin. That is, the pattern generator 21 serially inputs a test pattern, e.g., ("1", "0", "1") from the I/O pin lld (S41), "1" is held in the BS-FF 36 of the specified BS macro 12, and "0" is held in the BS-FF 35 of the specified BS macro 12. With this operation, a HIGH signal is output from the output buffer 26 connected to the testee pin (S42, S43).

Next, test data held in the BS-FFs 35 to 37 are shifted in accordance with the test clock (S44), whereby the BS-FF 37 of the specified BS macro 12 holds "1", the BS-FF 36 holds "0", and the BS-FF 35 holds "1". Then, the output buffer 26 is brought into a disable state, i.e., HZH state (HIGH level state of high impedance).

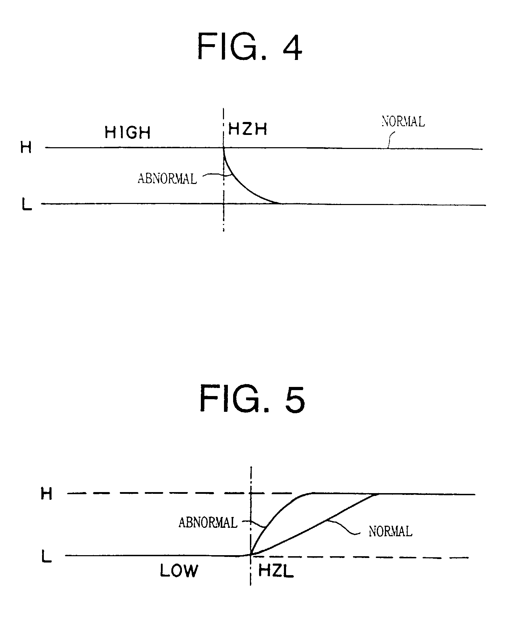

At that time, when the testee pin is normal, since the electric charge is accumulated in the capacitor C incorporated in the testee pin by the pull-up resistor 33 as shown in Fig.4, the HZH state is held for a relatively long time. Whereas, when the testee pin is short-circuited between the testee pin and the GDN (defective), the HZH state is shifted to an HZL state (LOW level state of high impedance) at time constant which is determined by the short resistor SH1 and a volume of the capacitor C incorporated in the testee pin.

For example, when a resistance value of the short resistor SH1 is in a range of 0.1 to 1k$\Omega$, a volume of the capacitor C is in a range of 2 to 5pF, the time constant is in a range of 0.2 to 5ns. A shift from the HZH state to the HZL state is conducted faster as the resistance value of the short resistor SH1 decreases.

By the shift from the HZH state to the HZL state, a voltage applied from the input buffer 34 to the BS-FF 37 is lowered. At that time, a voltage from the input buffer 34 becomes smaller than a threshold value held in the BS-FF 37, the content held in the BS-FF 37 is changed from "1" to "0" at an input timing of the test clock. A time required for changing the voltage level input to the BS-FF 37 from "1" to "O" is proportional to a time required for shifting from the HZH state to the HZL state.

For this reason, a time in which a voltage input to the BS-FF 37 is changed from "1" to "0" when a testee pin is normal becomes longer as compared with a case where the testee pin is abnormal. Thereupon, by measuring the time in which a voltage level output from the input buffer 34 is changed from "1" to "0", it is judged whether the testee pin is normal or abnormal.

A content held in a BS-FF 37 is obtained at the time when a test clock (TCK1) for changing a content of BS-FF 35 from "0" to "1" is input to the concerned BS-FF 35 and then, the next test clock (TCK2) is input to a BS-FF 37 (S45, S46), thereby judging whether the testee pin is normal or abnormal depending on whether the content held in the BS-FF 37 is "0" or "1".

That is, the content held in the BS-FF 37 when the TCK2 is input to the BS-FF 37 is taken out by the I/O pin 11o, and is transmitted to the pattern comparator 23. The pattern comparator 23 judges whether the content held in the BS-FF 37 when the TCK2 is input is changed from "1" to "0" (S47, S48). More specifically, the pattern comparator 23 compares a test pattern which was input and "1", "0", "1" which is a test pattern output from the pattern generator 21, and judges whether both of them coincide with each other.

At that time, when the testee pin is abnormal, since the test pattern input to the pattern comparator 23 has been changed to "0", "0", "1", the pattern comparator 23 judges that there is a short-circuit between the testee pin and the GND (S49). Whereas, when both of the test patterns coincide with each other, the pattern comparator 23 judges that the testee pin is normal (S50). Thereafter, the above-described third testing method is carried out for each of the remaining I/O pins 11. With this, each of the I/O pins lld to 11o is judged to be normal or abnormal.

An operating clock of the internal logic 13 may be used instead of the TCK2. Further, the TCK2 may be created by changing the timing of the normal test clock. Furthermore, this embodiment may alternatively measure a time from a period when the output buffer 26 is brought into the HZH state to a period when a content held in the BS-FF 37 is changed from "1" to "0". Further, the third testing method is applicable to a chip which does not include a pull-up resistor 33.

[Fourth Testing Method]

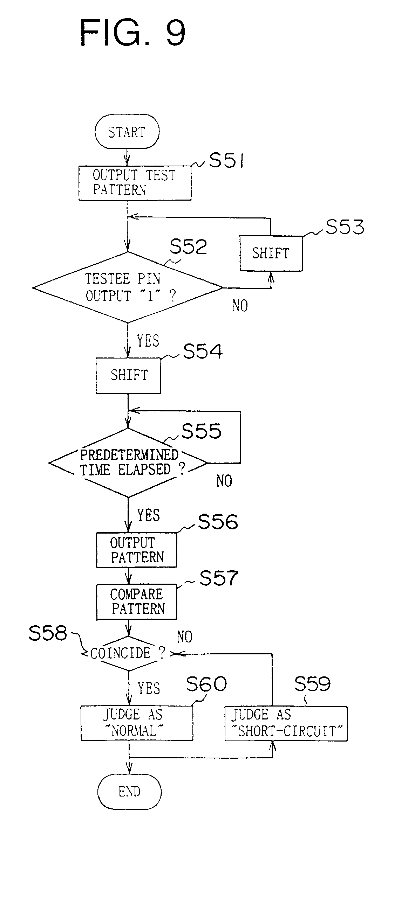

A quality test for the I/O pins 11d to 11o of the chip 10 by a fourth testing method (fourth embodiment) will be described with reference to a flowchart in Fig.9. The fourth testing method is a test for judging whether each of the I/O pins 11d to 11o is short-circuited with a voltage source (VDD).

First, the pattern generator 21 and the JTAG control circuit 15 specify one of BS macro among the BS macros 12a to 12l, and an I/O pin 11 connected to the specified BS macro 12 is determined as a testee pin, and a LOW signal is output from this testee pin. That is, the pattern generator 21 establishes a state in which a pattern, e.g., "0", "0", "1" is serially input from the I/O pin 11d (S51), "0" is held in the specified BS macro 12, and "0" is held in the BS-FF 35. With this operation, a LOW signal is output from the output buffer 26 connected to the testee pin (S52, S53).

Next, test data held in each of the BS-FFs 35 to 37 are sifted in accordance with the test clock (S54), whereby the BS-FF 37 of the specified BS macro 12 holds "0", the BS-FF 36 holds "0" and the BS-FF 35 holds "1". Then, the output buffer 26 is brought into a disable state, i.e., the HZL state.

At that time, when the testee pin is normal, the HZL state is shifted to the HLH state at time constant by the pull-up resistor 33 and the capacitor C incorporated in the testee pin. For example, when the resistance value of the pull-up resistor 33 is 0.1 to 1k$\Omega$, and a volume of the capacitor C is in a range of 2 to 5pF, the HZL state is shifted to the HZH state at time constant of 10 to 100ns.

Whereas, when the testee pin is short-circuited from itself to the voltage source VDD, the HZL state is shifted to the HZH state at time constant which is determined by the pull-up resistor 33, a parallel resistor of the short-resistor SH1 and a value of the capacitor C incorporated in the testee pin. For example, when the resistance value of the short resistor SH1 0.1 to 1k$\Omega$, and the capacitance C is in a range of 2 to 5pF, the HZL state is shifted to the HZH state at time constant of 0.2 to 5ns. In this manner, when the test pin is short-circuited with the voltage source VDD, the HZL state is shifted to the HZH state within shorter time as compared with a case where the testee pin is normal.

When the HZL state is shifted to the HZH state, a voltage input from the input buffer 34 to the BS-FF 37 is increased. At that time, when a voltage level from the input buffer 34 becomes equal to or greater than a threshold value held in the BS-FF 37, the BS-FF 37 changes the content held therein from "0" to "1". A time in which the voltage input to the BS-FF 37 is changed from "0" to "1" is proportional to a time in which the HZH state is shifted to the HZL state.

For this reason, a time in which a voltage input to the BS-FF 37 is changed from "0" to "1" when a testee pin is normal becomes longer as compared with a case where the testee pin is abnormal. Thereupon, a content held in a BS-FF 37 is obtained at the time when a test clock (TCK1) for changing a content of BS-FF 35 from "1" to "0" is input to the concerned BS-FF 35 and then, the next test clock (TCK2) is input to a BS-FF 37 (S55, S56), thereby judging whether the testee pin is normal or abnormal depending on whether the content held in the BS-FF 37 is "0" or "1".

That is, the content held in the BS-FF 37 when the TCK2 is input to the BS-FF 37 is taken out by the I/O pin 11o, and is transmitted to the pattern comparator 23. The pattern comparator 23 judges whether the content held in the BS-FF 37 when the TCK2 is input is changed from "0" to "1" (S57, S58). More specifically, the pattern comparator 23 compares a test pattern which was input and "0", "0", "1" which is a test pattern output from the pattern generator 21, and judges wither both of them coincide with each other.

At that time, when the testee pin is abnormal, since the test pattern input to the pattern comparator 23 has been changed to "1", "0", "1", the pattern comparator 23 judges that there is a short-circuit between the testee pin and the voltage source VDD (S59). Whereas, when both of the test patterns coincide with each other, the pattern comparator 23 judges that the testee pin is normal (S60). Thereafter, the above-described fourth testing method is carried out for each of the remaining I/O pins 11. With this, each of the I/O pins 11d to 11o is judged to be normal or abnormal.

[Effect of the Embodiments]

According to the first to fourth testing methods of the embodiments, it is possible to judge whether any of the I/O pins 11d to 11o is short-circuited with the GND or the voltage source VDD, even if the LSI tester 20 is not connected to all of the I/O pins 11d to 11o.

Further, test data for the I/O pins 11d to 11o are set using the BS macros 12a to 12l and the JTAG control circuit 15, five I/O pins 11a to 11d and 11o suffice as I/O pins for testing.

Furthermore, in each of the first and second testing methods, the test is conducted by detecting the power source electric current of the entire chip 10 flowing into the power source pin inherent in a chip which complies with the IEEE Standard 1149.1, and in each of the third and fourth testing methods, the test is conducted using only the BS macros 12a to 12l and JTAG control circuit 15. Therefore, when the present invention is put into operation, it is unnecessary to add a special structure to the chip 10.

As described above, it is possible to carry out a test for each one of a considerable amount of I/O pins provided in the electronic circuit (IC, LSI, ULSI) at lower costs, in a shorter time as compared with conventional methods, i.e., stably and effectively. Further, since it is unnecessary to connect the LSI tester 20 to all of the I/O pins 11d to 11o, it is possible to lower the possibility to physically damage the I/O pin or damage the circuit board. The testing methods of the present invention are effective especially for a chip 10 employing an area-bump system.

## Claims

1. A testing method of an electronic circuit including an internal logic circuit, a plurality of terminals of said internal logic circuit, and a boundary scan circuit interposed between the internal circuit and the plurality of terminals, said method comprising:

   a first step of setting test data in said boundary scan circuit such that signals of the same level are output from all terminals which are output terminals among said plurality of terminals;
   a second step of detecting a power source electric current of said electronic circuit when an output of each of said output terminals is in a state set in said first step;
   a third step of setting the test data in said boundary scan circuit such that any one of said output terminals outputs a signal of a level different from the signals output from the remaining output terminals;
   a fourth step of detecting a power source electric current of said electronic circuit when an output of each of said output terminals is in a state set in said third step; and
   a fifth step of judging whether said one terminal is normal or abnormal based on a difference between the power source electric current detected in said second step and the power source electric current detected in said fourth step.

2. A testing method of an electronic circuit as recited in claim 1, wherein

   in said first step, test data is set in said boundary scan circuit such that low level signals are output from all terminals which are output terminals among said plurality of terminals;
   in said third step, the test data is set in said boundary scan circuit such that any one of said output terminals outputs a high level signal and the remaining output terminals output low level signals; and
   in said fifth step, said one terminal is judged as abnormal, when the difference between the power source electric current detected in said second step and the power source electric current detected in said fourth step is smaller than a threshold value.

3. A testing method of an electronic circuit as recited in claim 1, wherein

   in said first step, test data is set in said boundary scan circuit such that high level signals are output from all terminals which are output terminals among said plurality of terminals;
   in said third step, the test data is set in said boundary scan circuit such that any one of said output terminals outputs a low level signal and the remaining output terminals output high level signals; and
   in said fifth step, said one terminal is judged as abnormal, when the difference between the power source electric current detected in said second step and the power source electric current detected in said fourth step is equal to or greater than a threshold value.

4. A testing method of an electronic circuit including an internal logic circuit, a plurality of terminals of said internal logic circuit, and a boundary scan circuit interposed between the internal circuit and the plurality of terminals, said method comprising:

   a first step of setting test data in said boundary scan circuit such that a signal of a predetermined level is output to a testee terminal among said plurality of terminals;

a second step of bringing an output to said testee terminal into a high impedance state; and

a third step of judging whether said testee terminal is normal or abnormal, based on a time in which a level of output to said testee terminal maintains said predetermined level after said high impedance state is established in said second step.

5. A testing method of an electronic circuit as recited in claim 4, wherein said boundary scan circuit comprises a buffer connected to said terminals, and test data holding means for holding test data to be supplied to said buffer, and wherein

in said first step, the test data is set in said test data holding means such that a signal of said predetermined level is output from said buffer;

in said second step, said buffer is set in a high impedance state; and

in said third step, said testee terminal is judged whether it is normal or abnormal, based on a time in which an output of said testee terminal maintains said predetermined level.

6. A testing method of an electronic circuit as recited in claim 5, wherein said boundary scan circuit comprises a buffer output holding means in which data having a level in accordance with an output of said buffer is stored, and wherein

in said third step, said testee terminal is judged whether it is normal or abnormal, based on a time in which said data stored in said buffer output holding means maintains a level in accordance with said predetermined level.

7. A testing method of an electronic circuit as recited in claim 6, wherein said third step detects a level of data stored in said buffer output holding means after a predetermined time has elapsed after said buffer is brought into the high impedance state.

8. A testing method of an electronic circuit as recited in any one of claims 4 to 7, wherein in said first step, said predetermined level is defined as a low level.

9. A testing method of an electronic circuit as recited in any one of claims 4 to 7, wherein in said first step, said predetermined level is defined as a high level.

10. A testing apparatus of an electronic circuit including an internal logic circuit, a plurality of terminals of said internal logic circuit, and a boundary scan circuit interposed between the internal circuit and the plurality of terminals, comprising:

control means, for setting a first state by setting test data in said boundary scan circuit such that signals of the same level are output from all terminals which are output terminals among said plurality of terminals, and for setting a second state by setting test data in said boundary scan circuit such that said output terminals except any one of them output signals of said level, and said one of the terminals outputs a signal of a different level;

electric current detecting means for detecting a power source electric current of said electronic circuit in said first state, and the power source electric current of said electronic circuit in said second state; and

judging means for judging whether said one of the terminals is normal or abnormal, based on a difference between the power source electric current of said electronic circuit in said first state, and the power source electric current of said electronic circuit in said second state.

11. A testing apparatus of an electronic circuit as recited in claim 10, wherein said control means sets said first state by setting the test data in said boundary scan circuit such that signals of low level are output from all of terminals which are output terminals, and sets said second state by setting the test data in said boundary scan circuit such that a signal of high level is output from any one of said output terminals, and signals of low level are output from the remaining output terminals; and

said judging means judges that said one of the terminals is abnormal when said difference in the power source electric current is smaller than a threshold value.

12. A testing apparatus of an electronic circuit as recited in claim 10, wherein said control means sets said first state by setting the test data in said boundary scan circuit such that signals of high level are output from all terminals which are output terminals, and sets said second state by setting the test data in said boundary scan circuit such that a signal of low level is output from any one of said output terminals, and signals of high level are output from the remaining output terminals; and

said judging means judges that said one of the terminals is abnormal when said difference in the power source electric current is equal to or greater than a threshold value.

13. A testing apparatus of an electronic circuit including an internal logic circuit, a plurality of terminals of said internal logic circuit, and a boundary scan circuit interposed between the internal circuit and the plurality of terminals, comprising:

control means for setting a first state by setting test data in said boundary scan circuit such that a signal of a predetermined level is output to a testee terminal among said plurality of terminals and then, said control means setting a second state by setting the test data in said boundary scan circuit such that the output to said testee terminal is brought into a high impedance state; and

judging means for judging, after said high impedance state is set by said control means, whether said testee terminal is normal or abnormal, based on a time in which the level of the output to said testee terminal maintains said predetermined level.

14. A testing apparatus of an electronic circuit as recited in claim 13, wherein said boundary scan circuit comprises a buffer connected to said terminals, and test data holding means for holding test data to be supplied to said buffer;

said control means sets said first state by storing the test data in said test data holding means such that the signal of said predetermined level is output from said buffer and then, said control means sets said second state by setting the test data in said test data holding means such that said buffer is brought into the high impedance state; and

said judging means judges whether said testee terminal is normal or abnormal based on a time in which the output of said buffer maintains said predetermined level.

15. A testing apparatus of an electronic circuit as recited in claim 14, wherein said boundary scan circuit further comprises buffer output holding means in which data of a level in accordance with the output of said buffer is stored; and

said judging means judges whether said testee terminal is normal or abnormal based on a time in which the data stored in said buffer output holding means a level in accordance with said predetermined level.

16. A testing apparatus of an electronic circuit as recited in claim 15, wherein said judging means detects a level of the data stored in said buffer output holding means after a predetermined time is elapsed after said buffer is brought into the high impedance state, and judges whether said testee terminal is normal or abnormal based said detected level.

17. A testing apparatus of an electronic circuit as recited in any one of claims 13 to 16, wherein said control means sets said first state by setting the test data in said boundary scan circuit such that a signal of low level is output to said testee terminal.

18. A testing apparatus of an electronic circuit as recited in any one of claims 13 to 16, wherein said control means sets said first state by setting the test data in said boundary scan circuit such that a signal of high level is output to said testee terminal.

# FIG. 1

# FIG. 2

TEST DATA REGISTER GROUP

I/O MACRO WITH BS FUNCTION

TDI 11d

BOUNDARY SCAN SECTION 24 28

MUX 27

MUX 25

OUTPUT BUFFER 26

11o TDO

DEVICE IDENTIFY REGISTER 29

USER TEST DATA REGISTER 30

BYPASS REGISTER 31

12

INSTRUCTION DECODER 18

INSTRUCTION REGISTER 17

SELECT   ENABLE

Clocks and/or Controls

JTAG CONTROL CIRCUIT 15

TMS
TCK
TRST

TAP CONTROLLER 16

16

# FIG. 3

# FIG. 4

HIGH ¦HZH          NORMAL

H ————————————————————————————

ABNORMAL

L ————————————————————————————

# FIG. 5

H – – – – – – – – – – – – – – – – – – – – –

ABNORMAL          NORMAL

L ————————————————————————————

LOW ¦HZL

# FIG. 6

START

OUTPUT TEST PATTERN "0" ～S1

ALL I/O PINS OUTPUT "0" ? — S2

NO

YES

MEASURE POWER SOURCE ELECTRIC CURRENT IDD1 ～S3

OUTPUT TEST PATTERN "1" ～S4

OUTPUT TEST PATTERN "0" S6

TESTEE PIN OUTPUT "1" ? S5

NO

YES

MEASURE POWER SOURCE ELECTRIC CURRENT IDD2 ～S7

SHIFT DATA S12

$IDD1-IDD2<THRESHOLD$ VALUE ? S8

YES

NO

JUDGE AS "NORMAL" S9

JUDGE AS "SHORT-CIRCUIT" ～S10

NO

TEST FOR ALL THE PINS COMPLETED ? S11

YES

END

19

# FIG. 7

```
                    ( START )
                        |
                        v  <------------------+
        +---------------------------+         |
        | OUTPUT TEST PATTERN       | S21     |
        |   "0""1""0"               |         |
        +---------------------------+         |
                        |                     |
                        v    S22         NO   |
                   /----------\ ----------->--+
                  /  ALL I/O PINS  \
                  \  OUTPUT "1" ?   /
                   \----------/
                        |
                      YES|
                        v
        +---------------------------+
        | MEASURE POWER SOURCE      | S23
        | ELECTRIC CURRENT IDD1     |
        +---------------------------+
                        |
                        v
        +---------------------------+
        | OUTPUT TEST PATTERN       | S24
        |   "0""0""0"               |
        +---------------------------+
                        |
    +-------------------+                        S26
    |                   v               +---------------------------+
    |              S25  |               | OUTPUT TEST PATTERN       |
    |                   v               |   "0""1""0"               |
    |              /----------\   NO    +---------------------------+
    |             /  TESTEE PIN \ -------->---------+
    |             \  OUTPUT "0" ? /
    |              \----------/
    |                   |
    |                 YES|
    |                   v
    |    +---------------------------+
    |    | MEASURE POWER SOURCE      | S27
    |    | ELECTRIC CURRENT IDD2     |
    |    +---------------------------+
    | S32               |
    |                   v   S28
 +---------+    NO  /----------\
 |SHIFT    |<------/ IDD1-IDD<THRESHOLD \
 |DATA     |       \  VALUE ?  /
 +---------+        \----------/
    |            S29      |
    |                   YES|
    |     +-----------+     v     +---------------------------+
    |     | JUDGE AS  |     | JUDGE AS                 | S30
    |     | "NORMAL"  |     | "SHORT-CIRCUIT"          |
    |     +-----------+     +---------------------------+
    |           |               |
    |           +------>--------+
    |     NO        v          S31
    +--------< TEST FOR ALL >
              < PINS COMPLETED ? >
                   |
                 YES|
                   v
               ( END )
```

# FIG. 8

# FIG. 9

```
                    START

              ┌──────────────┐    S51
              │ OUTPUT TEST  │
              │   PATTERN    │
              └──────────────┘
                                        ┌──────────┐  S53
                      S52               │  SHIFT   │
                 ╱──────────╲           └──────────┘
                ╱ TESTEE PIN ╲
                ╲ OUTPUT "1" ?╱──── NO
                 ╲──────────╱
                      │ YES      S54
              ┌──────────────┐
              │    SHIFT     │
              └──────────────┘
                                    S55
                 ╱────────────────╲
                ╱  PREDETERMINED   ╲
                ╲  TIME ELAPSED ?  ╱──── NO
                 ╲────────────────╱
                      │ YES      S56
              ┌──────────────┐
              │    OUTPUT    │
              │   PATTERN    │
              └──────────────┘
              ┌──────────────┐    S57
              │   COMPARE    │
              │   PATTERN    │
              └──────────────┘
         S58                NO
          ╱──────────╲
          ╲ COINCIDE ?╱ ──────────┐
           ╲────────╱              │
              │ YES    S60         │  S59
      ┌──────────────┐      ┌──────────────┐
      │  JUDGE AS    │      │  JUDGE AS    │
      │  "NORMAL"    │      │"SHORT-CIRCUIT"│
      └──────────────┘      └──────────────┘

                    END
```